# EUROPÄISCHE PATENTANMELDUNG

(11) **EP 1 700 936 A1**
(43) Veröffentlichungstag der Anmeldung: **13.09.2006**
(21) Anmeldenummer: 06004495.5
(22) Anmeldetag: 06.03.2006
(51) Int. Cl.: C30B 33/02, C30B 29/12, C30B 11/00

(54) **Verfahren zur Herstellung von hochhomogenen, spannungsarmen Einkristallen mit geringer Streuung**

(30) Priorität: 08.03.2005 DE 102005010654; 24.03.2005 DE 102005013876
(71) Anmelder: Schott AG, 55122 Mainz (DE)
(72) Erfinder: Poetsch, Christian, 07745 Jena (DE); Wehrhan, Gunther, 07749 Jena (DE); Parthier, Lutz, 14532 Kleinmachnow (DE); Axmann, Hans-Jörg, 07745 Jena (DE); Stäblein, Jörg, 07743 Jena (DE)
(74) Vertreter: Fuchs Mehler Weiss & Fritzsche

(57) **Zusammenfassung**

Es wird ein Verfahren zur Herstellung von hochhomogenen, spannungsarmen Einkristallen, insbesondere aus Calciumfluorid (CaF₂) beschrieben. Dabei wird ein mit einem geeigneten Verfahren in einer Schmelzvorrichtung gezüchteter Einkristall abgekühlt und anschließend einem Temperschritt unterzogen. Das Verfahren ist dadurch gekennzeichnet, dass der Einkristall nach der Kristallisierung bzw. nach seiner Züchtung im Temperaturbereich zwischen ≤ 1300°C und ≥ 1050°C einer raschen Abkühlung mit einer Rate von mindestens ≥ 10 K/h und vorzugsweise ≤ 60 K/h unterzogen wird.

## Beschreibung

Die vorliegende Erfindung betrifft ein Verfahren zur Herstellung von hochhomogenen, spannungsarmen Einkristallen.

Einkristalle werden als Alternative zu Quarzglas für optische Komponenten in der DUV-Fotolithographie benötigt. Sie werden üblicherweise als Linsen- oder Prismenmaterial verwendet und dienen insbesondere dazu, bei der Herstellung von elektronischen Geräten feine Strukturen auf integrierten Schaltungen, auf Computerchips und/oder auf Fotolack-beschichteten Wafern optisch abzubilden.

Dabei kommen insbesondere Calciumfluorid-Einkristalle zum Einsatz, weil sie bis weit in den UV-Bereich eine hohe Transmission aufweisen und sich daher auch für die Anwendung mit Excimerlasern eignen. Diese ermöglichen aufgrund ihrer Wellenlänge (KrF: 248 nm; ArF: 193 nm; F₂: 157 nm)) die lithographische Herstellung von Chipstrukturen mit einer Breite von weniger als 100nm.

Die Herstellung von Einkristallen sowie entsprechend großen optischen Elementen ist an sich bekannt. Sie können im Prinzip aus der Gasphase, der Schmelze, aus Lösungen oder sogar aus einer festen Phase durch Rekristallisation oder Festkörperdiffusion gezüchtet werden. Zur technischen Herstellung werden jedoch Einkristalle üblicherweise durch Erstarren einer Schmelze gezüchtet. Für die industrielle Fertigung von Einkristallen haben sich beispielsweise das so genannte Czochralski-Verfahren, das Bridgman-Stockbarger-Verfahren, und das Vertical Gradient Freeze-Verfahren durchgesetzt. Bei diesen Verfahren wird jeweils eine Kristallrohmasse aufgeschmolzen, und bei einer Temperatur oberhalb des Schmelzpunkts gehalten. Die geschmolzene Masse wird üblicherweise mit einem Impfkristall in Kontakt gebracht, an dem geschmolzenes Material nach und nach auskristallisiert, wodurch der Kristall wächst, und zwar in einer der Orientierung des Impfkristalls entsprechenden Ausrichtung. Anschließend wird der auf diese Weise erhaltene Einkristall auf Raumtemperatur abgekühlt.

Der für den Kristallzüchtungsprozess notwendige axiale Temperaturgradient sowie die während der Abkühlung des Kristalls auftretenden Temperaturgradienten führen zu Spannungen im Kristall, die zu einer Spannungsdoppelbrechung führen können. Üblicherweise bewegen sich die nach der Herstellung des Kristalls auftretenden Spannungsdoppelbrechungen im Bereich 5 - 20 nm/cm, was für die spätere Verwendung in der DUV-Fotolithografie zu groß ist. Zur Herstellung von optischen Elementen wird der Einkristall dann später zersägt und durch weiteres mechanisches Bearbeiten wie Fräsen und Polieren, kann sich die ohnehin hohe Spannungsdoppelbrechung noch weiter erhöhen.

Durch genaueste Temperatursteuerung während des Kristallisationsprozesses und des Abkühlprozesses einerseits sowie durch eine Verlangsamung der Abkühlgeschwindigkeit andererseits kann die Ausbildung von Spannungen im Kristall bis zu einem gewissen Grad reduziert werden. Aber auch solchermaßen hergestellte Einkristalle erfüllen die Anforderungen für die spätere Verwendung in der DW-Fotolithografie noch nicht.

Aus diesem Grund sind Versuche unternommen worden, die optischen Eigenschaften derart hergestellter Einkristalle dadurch zu verbessern, dass man diese nach erfolgter Abkühlung erneut über einen längeren Zeitraum auf eine Temperatur unterhalb des Schmelzpunktes erwärmt.

Diese als Tempern bezeichnete Erwärmung führt zu einer Umordnung der Atome im Kristallgitter durch Relaxations- und Diffusionsprozesse, wodurch sich sowohl mechanische Spannungen als auch Kristalldefekte auflösen oder zumindest verringern. Damit einher geht auch eine Reduktion der Spannungsdoppelbrechungen und der Gleitbänder sowie eine Erhöhung der Brechzahlhomogenität des Einkristalls.

Ein solches Verfahren ist z. B. aus der EP-A-939 147 bekannt, die die Herstellung von Calciumfluorid-Kristallen insbesonders für die Fotolithographie beschreibt. Dabei werden große Einkristalle in einem verschließbaren Behälter eingebracht und unter Vakuum auf eine erste Temperatur erhitzt, welche in einem Bereich von 1020 °C und 1150 °C liegt und danach mit einer Abkühlgeschwindigkeit von höchstens 1,2 - 2 K/h auf eine Temperatur von 600 - 900 °C in einer ersten Phase abgekühlt, woran sich eine Abkühlung auf Raumtemperatur mit einer Abkühlgeschwindigkeit von höchstens 5 K/h anschließt. In bevorzugten Ausführungsformen wird das Tempern in einer Fluorgas enthaltenden Atmosphäre sowie unter Schutzgas durchgeführt.

Mit Hilfe eines solchen Verfahrens können Spannungsdoppelbrechungen und Gleitbänder so weit reduziert werden, dass die so hergestellten Einkristalle den diesbezüglichen Anforderungen für die DUV-Fotolithografie genügen. Voraussetzung hierfür ist jedoch, dass bei der Abkühlung des Einkristalls unmittelbar nach dem Kristallisationsprozess eine gewisse Abkühlgeschwindigkeit nicht überschritten wurde, die durch die Abkühlung hervorgerufenen Spannungen also schon von vornherein auf ein gewisses Maß begrenzt wurden.

Durch die langsame Abkühlung entstehen jedoch neue Probleme: Kristallines CaF₂ weist eine sich mit zunehmender Temperatur erhöhende Löslichkeit für elementaren Sauerstoff auf. Trotz Prozessierung unter Vakuum und Verwendung von Scavenger-Additiven, die mit Sauerstoff zu leicht flüchtigen Oxiden reagieren, die bereits in der Schmelze verdampfen, liegt selbst im fertigen Einkristall noch gelöster Sauerstoff vor.

Bei der Abkühlung des gezüchteten Kristalls diffundiert der gelöste Sauerstoff im Kristallgitter und lagert sich mit weiterem Sauerstoff zu winzigen Oxid-Clustern zusammen.

Überschreiten diese entstehenden Clusterbereiche eine kritische Größe wirken sie als Streuzentren, an denen die so genannte Raleigh-Streuung induziert wird. Diese Art der Streuung wird durch Partikel mit einem Durchmesser von ≥ λ/20 (also mindestens einem 20stel der Lichtwellenlänge)hervorgerufen. Bei einer Lichtwellenlänge von 193 nm (ArF-Excimerlaser) würden in einem CaF₂-Einkristall also theoretisch Streupartikel mit Durchmessern von 9,7 nm ausreichen, um eine Lichtstreuung zu induzieren. Bei einer Lichtwellenlänge von 157 nm (F₂-Excimerlaser) würden dagegen theoretisch bereits Streupartikel mit Durchmessern von 7,85 nm ausreichen, um eine Lichtstreuung zu induzieren.

Ähnliche Probleme entstehen durch trotz Vakuumvorbehandlung und Vortemperierung des Schmelzguts im Kristallgitter gelöstes Restwasser, dass unter bestimmten Umständen mit Calcium zu Ca(OH)₂ und/oder CaO reagieren kann. Auch in diesem Fall wird die Diffusion des gebildeten Materials und damit dessen Aggregation durch die geringe Abkühlgeschwindigkeit begünstigt, so dass sich Streupartikel im Kristall bilden können.

Die Aufgabe der vorliegenden Erfindung liegt darin, ein Verfahren zur Herstellung von Einkristallen bereitzustellen, die nur geringe Spannungen aufweisen und damit einen geringen Anteil an Gleitbändern sowie eine hohe Brechzahlhomogenität, und die darüber hinaus nur eine geringe Streuung sowie einen verminderten Anteil an Schlieren und Kleinwinkelkorngrenzen aufweisen.

Diese Aufgabe wird mit den Merkmalen des vorliegenden Anspruchs 1 gelöst.

Die Erfindung betrifft daher ein Verfahren zur Herstellung von hochhomogenen, spannungsarmen Einkristallen, insbesondere aus Calciumfluorid (CaF₂), bei dem ein mit einem geeigneten Verfahren in einer Schmelzvorrichtung gezüchteter Einkristall abgekühlt und anschließend einem Temperschritt unterzogen wird. Das Verfahren zeichnet sich dadurch aus, dass der Einkristall nach seiner Züchtung, d. h. nach seiner Kristallisierung im Temperaturbereich zwischen 1300 °C und 1050 °C relativ rasch, d. h. mit einer Geschwindigkeit von mindestens 10 K/h abgekühlt wird. Dies erfolgt insbesonders im Anschluss an seine Züchtung, d. h. bei der ersten Abkühlung des noch heißen fertigen Kristalls. Dabei ist es bevorzugt, den Kristall zu keinem späteren Zeitpunkt mehr auf Temperaturen oberhalb 1100°C zu erwärmen, und zwar weder ganz noch teilweise. Besonders bevorzugt wird der Einkristall nach seiner Züchtung nicht wieder auf eine Temperatur oberhalb 1075°C bzw. 1050°C erwärmt.

In Versuchen der Anmelderin wurde nämlich gefunden, dass dieser Temperaturbereich in Bezug auf die Ausbildung von Streupartikeln, Schlieren und Kleinwinkelkorngrenzen besonders sensibel ist. Durch die Erhöhung der Abkühlungsrate in diesem Bereich wird die Bildung von Streupartikeln und Schlieren unterbunden bzw. können ggf. entstehende Streupartikel unter der für die Raleigh-Streuung kritischen Größe gehalten werden.

Gleichzeitig wird durch die beschleunigte Abkühlung in diesem Temperaturbereich die Ausbildung von Kleinwinkelkorngrenzen reduziert bzw. ganz vermieden.

Vorzugsweise liegt die Obergrenze des Temperaturbereiches, in dem rasch abgekühlt wird, unterhalb 1200 °C, insbesonders unterhalb 1185°C, wobei unterhalb 1175°C besonders bevorzugt ist. Die Untergrenze dieses Bereiches liegt vorzugsweise oberhalb 1050°C, und insbesonders oberhalb 1075°C, wobei oberhalb 1100°C ganz besonders bevorzugt ist. Bevorzugte Abkühlungsgeschwindigkeiten oder -raten betragen für diesen Temperaturbereich mindestens 20 K/h. Die bevorzugte maximale Abkühlgeschwindigkeit beträgt 65 K/h, insbesonders max. 50 K/h, wobei max. 45 und speziell max. 40 K/h ganz besonders bevorzugt ist.

Insbesonders erfolgt die rasche Abkühlung erfindungsgemäß über den gesamten zuvor definierten Temperaturbereich hinweg.

Erfindungsgemäß wurde gefunden, dass dieser Temperaturbereich besonders kritisch für die Ausbildung von Streupartikeln, Schlieren und Kleinwinkelkorngrenzen ist. Gerade in diesem Temperaturbereich kann daher eine erhöhte Abkühlungsrate zu einer deutlichen Verminderung dieser Phänomene führen.

Besonders bevorzugt ist dabei vorgesehen, dass der Einkristall in dem obigen Temperaturbereich einer Abkühlung mit einer Rate zwischen ≥ 20 K/h und ≤ 40 K/h unterzogen wird. Bei einer solchen Abkühlungsrate wird die Ausbildung von Streupartikeln, Schlieren und Kleinwinkelkorngrenzen ganz besonders effektiv unterdrückt.

Es hat sich gezeigt, dass die erfindungsgemäße höhere Abkühlungsrate zwar die Ausbildung von thermischen Spannungen, eine höhere Versetzungsdichte und die Ausbildung von Gleitbändern begünstigt und damit die Brechzahlhomogenität verschlechtert. Jedoch wurde auch gefunden, dass diese durch geeignetes weiteres, relativ langsames Abkühlen unterhalb des zuvor definierten Temperaturbereiches der relativ raschen Abkühlung gering gehalten werden.können.

Daher ist in einer bevorzugten Ausgestaltung des erfindungsgemäßen Verfahrens vorgesehen, dass der Einkristall nach seiner raschen Abkühlung im Anschluss an die Kristallzucht im Temperaturbereich unterhalb 1075 °C und insbesonders unterhalb 1050°C bzw. unterhalb 1000°C bis zu einer Temperatur von ca. 900°C mit einer Rate kleiner als 10 K/h, bevorzugt kleiner als 5 K/h abgekühlt wird. Auf diese Weise wird die Ausbildung extremer thermischer Spannungen im Kristall und die damit verbundenen nachteiligen Erscheinungen - trotz vorheriger schnellerer Abkühlungsrate - gering gehalten.

Trotz dieser Maßnahmen führt die erhöhte Abkühlungsrate im Einkristall zu erheblichen Spannungen, die zur Ausbildung von Gleitbändern führen und die Brechungshomogenität des Kristalls negativ beeinflussen. Diese Spannungen werden durch den sich anschließenden Temperschritt reduziert. Dieser Schritt kann als Prozess-Schritt unmittelbar in der Schmelzvorrichtung oder aber auch als separater Prozess in einem speziellen Ofen durchgeführt werden.

Dabei ist vorgesehen, dass der Temperschritt ein Aufheizen des Einkristalls auf eine Temper-Temperatur umfasst, die unterhalb des Schmelzpunktes des Einkristalls liegt.

In einer bevorzugten Ausgestaltung des Verfahrens ist jedoch vorgesehen, dass der Temperschritt ein Aufheizen des Einkristalls auf eine Temper-Temperatur zwischen 1050°C und 1150°C, ggf. bis 1100°C umfasst.

Wichtig dabei ist, dass der Einkristall nicht höher als 1150 °C erhitzt wird, da gefunden wurde, dass Temperaturen oberhalb davon überraschenderweise die Ausbildung von Subkornstrukturen im Kristall begünstigen. Außerdem wird dann erneut die Bildung von Streupartikeln und Schlieren begünstigt.

Besonders bevorzugt ist vorgesehen, dass der Einkristall während des Temperschritts mit einer Rate zwischen 5 K/h und 50 K/h auf die Temper-Temperatur aufgeheizt wird. Außerdem hat es sich als günstig erwiesen, den Einkristall für einen Zeitraum im Bereich zwischen 24 und 240 h auf der Temper-Temperatur zu halten. Prinzipiell sind jedoch auch kürzere oder längere Temperzeiträume möglich

Während dieser Haltephase werden die im Kristall bestehenden Spannungen durch Relaxations- und Diffusionsprozesse abgebaut, mit der Folge, dass die inhärenten Spannungen und damit Gleitbänder beseitigt werden und die Brechzahlhomogenität des Kristalls wesentlich verbessert wird.

Entscheidend für den Erfolg des Temperschritts ist, dass der Einkristall nach erfolgter Wärmebehandlung sehr langsam wieder abgekühlt wird, um nicht erneut das Auftreten von thermischen Spannungen zu provozieren. Daher ist bevorzugt, den Einkristall nach dem Temperschritt im Temperaturbereich zwischen Temper-Temperatur und 800 °C in Abhängigkeit von Größe und Orientierung des Kristalls mit einer Rate zwischen 0,1 und 1,5 K/h abzukühlen.

Im Temperaturbereich unterhalb 800°C kann der Einkristall dagegen einer Abkühlung mit einer etwas höheren Rate unterzogen werden, die vorzugsweise im Bereich von 0,3 bis 3 K/h liegt. Mit diesen Geschwindigkeiten bzw. Raten kann dann der Einkristall auf Raumtemperatur bzw. sogar bis 0°C oder darunter abgekühlt werden.

Grundsätzlich ist vorgesehen, dass der Einkristall mit einem Verfahren hergestellt wird, das ausgewählt ist aus der Gruppe bestehend aus Czochralski-Verfahren, Zonenschmelzverfahren, Bridgman-Stockbarger-Verfahren, und Vertical-Gradient-Freeze-Verfahren. Diese Verfahren haben sich für die industrielle Zucht von Einkristallen als besonders geeignet erwiesen. Es ist jedoch ebenso gut denkbar, ein anderes Kristallzüchtungsverfahren aus dem Stand der Technik zu verwenden, bei dem der Kristall aus der Schmelze gezogen wird.

Die optische Güte des hergestellten Einkristalls hängt außerdem von einer Reihe anderer Faktoren ab. So ist von entscheidender Bedeutung, dass der Kristall möglichst nicht durch Verunreinigungen beeinträchtigt wird.

Daher ist bevorzugt vorgesehen, dass das für die Kristallzüchtung verwendete Rohmaterial einen Sauerstoffgehalt von ≤ 3 ppm und/oder einen Gehalt an Übergangsmetallen von insgesamt ≤ 1 ppm aufweist. Auf diese Weise kann z. B. die Bildung von Streupartikeln bereits durch die Wahl des geeigneten Vorprodukts reduziert werden.

Ein bevorzugtes Kristallmaterial sind Alkali- und/oder Erdalkalihalogenide, sowie Mischungen davon. Bevorzugte Halogenide sind Fluoride, Chloride und/oder Bromide, wobei Fluorid ganz besonders bevorzugt ist. Bevorzugte Alkalimetallionen sind Natrium, Kalium und/oder Lithium und bevorzugte Erdalkalimetallionen sind Magnesium, Calcium, Barium und/oder Strontium. Auch Mischkristalle davon sind bevorzugt. Besonders bevorzugt sind Mischkristalle der allgemeinen Formel BaₓSr₁₋ₓF₂ und BaₓCa₁₋ₓF₂ für x gleich 0 bis 1 und BaₓCa₁₋ₓF₂ mit x ungefähr 0,1 ± 0,02.

Für eine optimale Wärmeübertragung sind Schmelzvorrichtungen für die Kristallzucht häufig mit Graphit-Suszeptoren ausgekleidet. Überdies ist Graphit beständig gegen sich ggf. bildende Flusssäure und schützt so die Schmelzvorrichtung vor Korrosion. Graphit sorgt außerdem für die Schaffung einer reduzierenden Atmosphäre während des Temperschritts, indem es mit ggf. vorhandenem Restwasser bei den herrschenden Bedingungen unter Ausbildung von Kohlenmonoxid, Kohlendioxid und Methan reagiert. Auf diese Weise kann im Einkristall vorliegendes CaO zu CaF₂ reduziert werden, was wiederum zu einer Verringerung der Schlieren und - durch Reduktion der Kristallbaufehler - zu einer Verminderung der Kleinwinkelkorngrenzen führt.

In einer besonders bevorzugten Ausgestaltung des erfindungsgemäßen Verfahrens ist daher vorgesehen, dass als Auskleidung der Schmelzvorrichtung Graphit verwendet und/oder dem Einkristall während des Temperns Graphit hinzugefügt wird. In beiden Fällen ist bevorzugt vorgesehen, dass Graphit mit einer Verunreinigungsrate ≤ 20ppm verwendet wird.

Ebenso ist bevorzugt vorgesehen, dass die bei der Schmelzung, der Kristallzüchtung, dem Abkühlen und/oder dem Temperschritt verwendeten Gase eine Reinheit von ≥ 99,999 %, bevorzugt von ≥ 99,9999 % aufweisen, und/oder dass zur Entfernung der Restfeuchte in der Schmelzvorrichtung ein Vakuum mit einem Druck von ≤ 5 x10⁻⁶ mbar eingestellt wird.

Eine weitere bevorzugte Ausgestaltung des erfindungsgemäßen Verfahrens sieht vor, dass das Schmelzen, die Kristallzüchtung, das Abkühlen und/oder der Temperschritt in Gegenwart eines Scavengers durchgeführt wird, der ausgewählt ist aus der Gruppe bestehend aus SnF₂, PbF₂, ZnF₂ und XeF₂. Dabei reagieren die zugesetzten Scavenger mit dem zum Teil noch aus der Rohmasse stammenden, zum Teil aber auch durch Oxidation und/oder Hydrolyse während der Kristallisation entstandenen Sauerstoff zu leicht flüchtigen Oxiden, welche bei dieser Temperatur verdampfen.

Ebenso geeignet sind gasförmige Scavenger wie z.B. Fluorgas, Mischungen aus Fluorgas und Inertgas, Fluorkohlenstoffgase bzw. Fluorkohlenwasserstoffgase, sowie Mischungen letzterer mit Inertgas. Besonders bevorzugt sind Mischungen aus Fluorkohlenstoffgasen mit Inertgas mit einer resultierenden Fluorkohlenstoffgas-Konzentration von 1 - 50 %, insbesondere 5 - 30 %. Der Einsatz eines solchen Gasgemisches führt - anders als bei Verwendung von reinem Inertgas, Vakuum oder pulverförmigen Scavengern - zu einer Verbesserung der Transmission des Einkristalls. Gas- und pulverförmige Scavenger können auch gemeinsam eingesetzt werden.

Um eine hohe Genauigkeit bei der Bildung des Einkristalls zu gewährleisten und Kristallbaufehler möglichst auszuschließen, ist vorgesehen, dass während der Kristallzüchtung Wachstumsgeschwindigkeiten von ≤ 0,5 mm/h eingestellt werden. Dies geschieht zweckmäßigerweise durch genaue Einstellung der Temperatur während des Kristallisationsprozesses.

Die hohen Anforderungen an die Spannungsfreiheit der Kristalle werden insbesondere dann erfüllt, wenn neben der Reduzierung der dynamischen Temperaturgradienten durch Heiz- oder Abkühlprozesse auch die statischen Temperaturgradienten im Kristall verringert werden. Diese werden durch die räumliche Temperaturverteilung in der Schmelzvorrichtung bzw. im Temperofen verursacht und können ebenso zur Ausbildung von Spannungen im Kristall führen. Durch geeignetes Design der jeweiligen Vorrichtung können die statischen Temperaturgradienten in engen Grenzen gehalten werden.

In einer weiteren bevorzugten Ausgestaltung des erfindungsgemäßen Verfahrens ist daher vorgesehen, dass während der Abkühlung und/oder dem Temperschritt im Einkristall statische Temperaturgradienten ≤ 0,3 K/cm eingestellt werden. Besonders bevorzugt werden dabei statische, radiale Temperaturgradienten von ≤ 0,013 K/cm und statische, axiale Temperaturgradienten von ≤ 0,07 K/cm eingestellt. Diese Angaben beziehen sich auf die statischen Temperaturgradienten im Ofen bzw. der Zucht- oder Tempervorrichtung.

Die Erfindung betrifft weiterhin einen Einkristall, der mit dem erfindungsgemäßen Verfahren hergestellt werden kann. Der Einkristall ist dadurch gekennzeichnet, dass er eine freie Versetzungsdichte von ≤ 2,5 × 10³/cm³ vorzugsweise ≤ 2,0 × 10³/cm³ und insbesonders ≤ 1,5 × 10³/cm³ aufweist, der Kristall weniger Kleinwinkelkorngrenzenflächen als 2cm²/cm³ bzw. 1,5 und insbesonders 1,0 cm²/cm³ aufweist, die Verkippungswinkel zwischen den benachbarten Körnern ≤ 100 arcsec, insbesonders ≤ 90 bzw. ≤ 80 arcsec betragen, die Gesamtorientierungsgenauigkeit im Einkristall bzw. einer Scheibe davon ≤ 8 Winkelminuten, insbesonders ≤ 7 bzw. ≤ 6 Winkelminuten beträgt, die Brechzahlinhomogenität nach Abzug der 36 ersten Zernike-Koeffizienten ≤ 2, insbesonders ≤ 1, 2×10⁻⁸ bzw. 1,0×10⁻⁸ ist, die mittlere Spannungsdoppelbrechung (RMS-Wert) in 111-Richtung ≤ 0,4 nm/cm bzw. ≤ 0,3 nm/cm und in 100-Richtung ≤ 0,7 nm/cm bzw. ≤0,6 nm/cm und insbesonders ≤ 0,5 nm/cm beträgt und/oder der Einkristall nach ISO 13696 eine maximale Streuung TS≤2x10⁴ bzw. ≤ 1,5 x 10⁴, insbesonders ≤ 1 x 10⁴ aufweist. Dabei bedeuten TS die Gesamtstreuung (total scattering) und TIS die integrierte Gesamtstreuung (total integrated scattering).

Vorzugsweise weisen die erfindungsgemäßen Kristalle diese Werte bei einem Durchmesser von mindestens 100 mm, insbesonders mindestens 150 mm und/oder einer Dicke von mindestens 20 mm, insbesonders mindestens 30 mm auf. Zweckmäßige Obergrenzen betragen max. 400 mm, insbesonders max. 300 mm für den Durchmesser und max. 150 mm, insbesonders 100 mm für die Dicke, wobei diese maximalen Werte bei Bedarf auch überschritten werden können.

Erfindungsgemäß ist weiterhin die Verwendung eines solchen Einkristalls zur Herstellung von optischen Komponenten und/oder elektronischen Komponenten vorgesehen. Hierbei kann es sich z.B. um Linsen, Prismen, Lichtleitstäbe, optische Komponente für die DUV-Fotolithographie, Stepper, Excimerlaser, Wafer, Computerchips, integrierte Schaltungen und elektronischen Geräten, die solche Schaltungen und Chips enthalten.

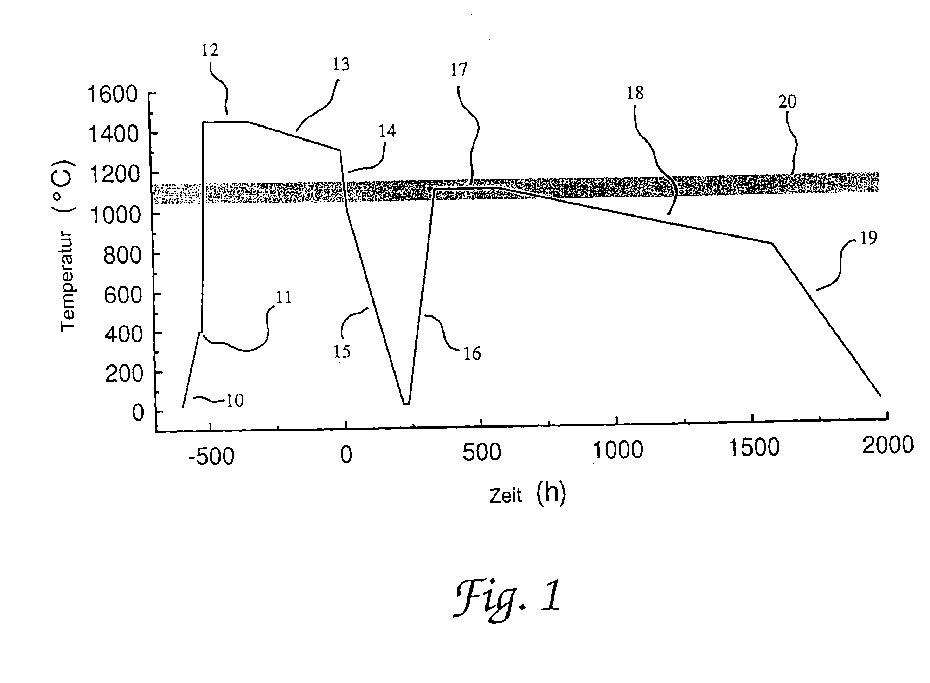

Die Erfindung soll anhand der Fig.1 beispielhaft erläutert werden.

Fig. 1 zeigt ein beispielhaftes Temperaturprofil für die Durchführung eines erfindungsgemäßen Verfahrens.

Zur Herstellung der Einkristalls gemäß einem der erfindungsgemäßen Verfahren wird die Kristallrohmasse, nämlich polykristallines CaF₂, ausgehend von Raumtemperatur (10) in einer Schmelzvorrichtung langsam auf eine Temperatur (11) von etwa 400 °C erhitzt und einige Zeit bei dieser Temperatur gehalten, um die Rohmasse zu entwässern. Danach wird die Temperatur über einem Zeitraum von 20 Stunden auf eine Temperatur (12) von 1450 °C erhöht, und eine Woche bei dieser Temperatur gehalten, wobei durch Scavenger wie SnF₂, PbF₂, ZnF₂ und XeF₂, die der Rohmasse beigemischt wurden, der restliche gelöste Sauerstoff entfernt wird. Nach einer Woche wird die Schmelze einer langsamen zweiwöchigen Abkühlung (13) auf etwa 1300 °C unterzogen, wobei der gewünschte Einkristall auf bekannte Weise aus der Schmelze auskristallisiert. Der so erhaltene Einkristall wird dann in einer ersten schnellen Abkühlphase (14) mit einer Abkühlungsrate von 15 K/h auf 1000 °C abgekühlt, und anschließend in einer zweiten verlangsamten Abkühlphase (15) mit einer Abkühlungsrate von 5 K/h auf Raumtemperatur abgekühlt.

Der abgekühlte Einkristall wird dann aus der Schmelzvorrichtung entnommen und in einem Temperofen überführt. Anschließend wird der Einkristall in einer Heizphase (16) mit einer Rate von 10 K/h auf eine Temper-Temperatur (17) in Höhe von 1100 °C aufgeheizt und 240 h bei dieser Temperatur gehalten, um die Spannungen im Kristall abzubauen und so die Gleitbänder zu reduzieren und die Brechzahlhomogenität zu erhöhen. Wichtig dabei ist, dass der Einkristall nicht auf eine Temperatur oberhalb 1150 °C erhitzt wird, da es sich gezeigt hat, dass solche Temperaturen die Ausbildung einer Zellularstruktur im Kristall bis hin zur Subkorngrenze begünstigen, und eine Bildung von Streupartikeln und Schlieren ermöglichen.

Anschließend wird der Einkristall in einer ersten Abkühlphase (18) mit einer Rate von 0,3 K/h auf eine Temperatur von 800 °C abgekühlt, und dann in einer zweiten Abkühlphase (19) mit einer Rate von 2 K/h auf Raumtemperatur abgekühlt.

Ein solchermaßen hergestellter CaF₂-Einkristall weist eine Brechzahlhomogenität auf, die nach Abzug von 36 Zernike-Koeffizienten unterhalb von 1,2×10⁻⁸ liegt. Der Mittelwert der Spannungsdoppelbrechung in 111-Richtung liegt unterhalb von 0,4 nm/cm und in 100-Richtung unterhalb von 0,7 nm/cm. Überdies weist der Einkristall nur eine Streuung TS < 2x10⁴ auf.

In Fig. 1 ist der kritische Temperaturbereich, der beim Tempern nicht überschritten werden darf und der andererseits bei der vorherigen Abkühlung möglichst rasch durchschritten werden muss, als grauer Balken (20) dargestellt.

## Patentansprüche

1. Verfahren zur Herstellung von hochhomogenen, spannungsarmen, großvolumigen Einkristallen, insbesondere aus Calciumfluorid (CaF₂), bei dem aus einer Schmelze ein Einkristall gezüchtet, anschließend abgekühlt und einem Tempern unterzogen wird, **dadurch gekennzeichnet, dass** das Abkühlen des Einkristalls nach seiner Züchtung im Temperaturbereich zwischen 1300°C und 1050°C mit einer Rate von mindestens 10 K/h erfolgt.

2. Verfahren nach Anspruch 1, **dadurch gekennzeichnet, dass** der Einkristall nach dem Abkühlen nicht wieder auf eine Temperatur oberhalb 1100°C erwärmt wird.

3. Verfahren gemäß einem der vorherigen Ansprüche, **dadurch gekennzeichnet, dass** der Einkristall nach seiner Kristallisierung im Temperaturbereich unterhalb 1050°C mit einer Rate kleiner als 10 K/h abgekühlt wird.

4. Verfahren gemäß einem der vorherigen Ansprüche, **dadurch gekennzeichnet, dass** der Einkristall bei der Abkühlung nach der Kristallisierung im Temperaturbereich unterhalb 1050°C mit einer Rate kleiner als 5 K/h unterzogen wird.

5. Verfahren gemäß einem der vorherigen Ansprüche, **dadurch gekennzeichnet, dass** der Temperschritt ein Aufheizen des Einkristalls auf eine Temper-Temperatur zwischen 1050 °C und 1150 °C umfasst.

6. Verfahren gemäß einem der vorherigen Ansprüche, **dadurch gekennzeichnet, dass** der Einkristall während des Temperschritts mit einer Rate zwischen 18 K/h und 0,01 K/h aufgeheizt wird.

7. Verfahren gemäß einem der vorherigen Ansprüche, **dadurch gekennzeichnet, dass** der Einkristall für einen Zeitraum zwischen 24 und 240 h auf der Temper-Temperatur gehalten wird.

8. Verfahren gemäß einem der vorherigen Ansprüche, **dadurch gekennzeichnet, dass** der Einkristall nach dem Tempern bis auf eine Temperatur von 800°C mit einer Rate zwischen 0,1 und 1,5 K/h abgekühlt wird.

9. Verfahren gemäß einem der vorherigen Ansprüche, **dadurch gekennzeichnet, dass** der Einkristall nach dem Tempern im Temperaturbereich unterhalb 800 °C mit einer Rate von 0,3 bis 3 K/h abgekühlt wird.

10. Verfahren gemäß einem der vorherigen Ansprüche, **dadurch gekennzeichnet, dass** der Einkristall aus einem Rohmaterial gezüchtet wird, das einen Sauerstoffgehalt von ≤ 3 ppm und/oder einen Gehalt an Übergangsmetallen von insgesamt ≤ 1 ppm aufweist.

11. Verfahren gemäß einem der vorherigen Ansprüche, **dadurch gekennzeichnet, dass** das Schmelzen, die Kristallzüchtung, das Abkühlen und/oder der Temperschritt in Gegenwart eines Scavengers durchgeführt wird, der ausgewählt ist aus der Gruppe bestehend aus SnF₂, PbF₂, ZnF₂ und XeF₂.

12. Verfahren gemäß einem der vorherigen Ansprüche, **dadurch gekennzeichnet, dass** das Schmelzen, die Kristallzüchtung, das Abkühlen und/oder der Temperschritt in Gegenwart eines gasförmigen Scavengers durchgeführt wird, der ausgewählt ist aus der Gruppe bestehend aus Fluorgas, Mischungen aus Fluorgas und Inertgas, Fluorkohlenstoffgas, Fluorkohlenwasserstoffgas, sowie Mischungen letzterer mit Inertgas.

13. Einkristall, erhältlich mittels dem Verfahren gemäß einem der vorherigen Ansprüche, **dadurch gekennzeichnet, dass** der Einkristall eine freie Versetzungsdichte von ≤ 2,5 x 10³/cm³ aufweist, Kleinwinkelkorngrenzenflächen von weniger als 2cm²/cm³ aufweist, die Verkippungswinkel zwischen den benachbarten Körnern ≤ 100 arcsec betragen, die Verkippung zwischen beliebigen Körnern ≤ 8 Winkelminuten beträgt, die Brechzahlhomogenität nach Abzug von 36 ersten Zernike-Koeffizienten für Scheiben ≤ 1,2×10⁻⁸ ist, der Mittelwert der Spannungsdoppelbrechung für Scheiben in 111-Richtung ≤ 0,4 nm/cm und in 100-Richtung ≤ 0,7 nm/cm ist und/oder der Einkristall maximal eine Streuung TS≤2x10⁴ (nach ISO 13696) aufweist.

14. Verwendung von nach dem Verfahren der Ansprüche 1-13 erhaltenen Einkristallen zur Herstellung von Linsen, Prismen, Lichtleitstäben, optischen Komponenten für die DUV-Fotolithographie, Steppern, Excimerlasern, Computerchips, integrierten Schaltungen und elektronischen Geräten, die solche Schaltungen und Chips enthalten.
